# EUROPÄISCHE PATENTANMELDUNG

(11) **EP 0 961 535 A1**
(43) Veröffentlichungstag der Anmeldung: **01.12.1999**
(21) Anmeldenummer: 98109433.7
(22) Anmeldetag: 25.05.1998
(51) Int. Cl.: H05K 7/14

(54) **Befestigungselement zur beabstandeten Befestigung einer Leiterplatte auf einem elektrisch leitenden Träger**

(71) Anmelder: Elpro S.A., 94507 Champigny Cedex (FR)
(72) Erfinder: Prabonnaud, Jean-François, 77340 Pontault-Combault (FR); Wegmann, George, Dr., 75012 Paris (FR); Leroy, Roger, 77185 Lognes (FR); Vassal, Jean-Louis, 77380 Combs-la-Ville (FR)
(74) Vertreter: Dittrich, Horst, Dr.

(57) **Zusammenfassung**

Das Befestigungselement (3) besteht aus einem auf dem Träger (1) fixierbaren Distanzierungsmittel (4) zur Auflage der Leiterplatte (2) und aus einem elektrisch leitenden Befestigungsmittel (5) zur Herstellung einer mechanischen, und elektrisch leitenden Verbindung zwischen der Leiterplatte (2) und dem Träger (1). Das Distanzierungsmittel (4) weist einen hülsenförmigen Distanzierungsteil und einen an diesen angearbeiteten Befestigungsteil auf. Der letzere ist durch zwei elastische, finger-oder flügelartige Befestigungsorgane (9) gebildet, die zum Eingriff in entsprechende Ausnehmungen (7) des Trägers (1) vorgesehen sind. Das Befestigungsmittel (5) ist durch eine Schraube gebildet, die beim Anziehen in den Träger (1) hineingedreht wird.

## Beschreibung

Die vorliegende Erfindung betrifft ein Befestigungselement zur beabstandeten Befestigung einer Leiterplatte auf einem elektrisch leitenden Träger unter Herstellung einer elektrisch leitenden Verbindung zwischen Leiterplatte und Träger.

Derartige Befestigungselemente werden beispielsweise für die Montage von Leiterplatten in einem Gehäuse verwendet, wobei die Leiterplatten einen bestimmten Abstand von dem elektrisch leitenden oder metallischen Träger einzunehmen haben. Die Befestigungselemente, von denen beispielsweise vier Stück pro Leiterplatte verwendet werden können, müssen möglichst einfach aufdem Träger fixierbar sein, damit die Leiterplatte in die gewünschte Lage gebracht werden kann und Arbeitskosten eingespart werden können. Ausserdem müssen sie aber auch so ausgebildet sein, dass zwischen Leiterplatte und Träger eine stabile und doch einfach lösbare mechanische und elektrisch leitende Verbindung hergestellt werden kann. Dabei ist zu beachten, dass auch solche Leiterplatten, die in fest montierten und nur erschwert zugänglichen Gehäusen montiert sind, möglichst bequem ein- und ausbaubar sein sollten.

Aufgrund des Gesagten sollte klar sein, dass die an sich naheliegende Lösung, nämlich eine konventionelle Befestigung mittels einer Distanzhülse und einer durch diese geführten Schraube und Mutter ausscheidet, weil die Distanzhülse nicht aufdem Träger fixiert werden kann, sondern von Hand in der gewünschten Position gehalten werden muss, was zu umständlich und nicht bedienungsfreundlich ist. Ausserdem steht in der Regel nicht ausreichend Platz zur Verfügung, um die Mutter von der Rückseite des Trägers oder Gehäuses her gezielt auf die Schraube zu schrauben.

Bekannte dübelartige Befestigungselemente aus Plastik, welche elastische Befestigungsflügel aufweisen, die in entsprechende Ausnehmungen des Trägers eingesteckt werden, wodurch das Befestigungselement auf dem Träger fixiert wird, sind ebenfalls nicht geeignet, weil mit ihnen keine elektrisch leitende Verbindung hergestellt werden kann. Und die Verwendung einer zusätzlichen Schraube und Mutter scheidet aus den genannten Gründen aus.

Durch die Erfindung soll nun ein Befestigungselement der eingangs genannten Art angegeben werden, welches möglichst einfach und sicher handhabbar ist und eine bequeme Befestigung der Leiterplatte aufdem Träger sowie die Herstellung einer elektrischen Verbindung mit diesem ermöglicht und somit insbesondere für einen raschen und einfachen Ein- und Ausbau von Leiterplatten in Gehäuse bzw. aus diesen geeignet ist.

Diese Aufgabe wird erfindungsgemäss dadurch gelöst, dass das Befestigungselement aus einem auf dem Träger fixierbaren Distanzierungsmittel zur Auflage der Leiterplatte und aus einem elektrisch leitenden Befestigungsmittel zur Herstellung einer mechanischen und elektrisch leitenden Verbindung zwischen der Leiterplatte und dem Träger besteht.

Eine erste bevorzugte Ausführungsform des erfindungsgemässen Befestigungselements ist dadurch gekennzeichnet, dass das Distanzierungsmittel aus einem Kunststoffmaterial besteht und einen hülsenförmigen Distanzierungsteil sowie einen an diesen angearbeiteten Befestigungsteil aufweist.

Eine zweite bevorzugte Ausführungsform des erfindungsgemässen Befestigungselements ist dadurch gekennzeichnet, dass der Befestigungsteil durch zwei elastische, finger- oder flügelartige und zum Eingriff in entsprechende Ausnehmungen des Trägers vorgesehene Befestigungsorgane gebildet ist.

Eine dritte bevorzugte Ausführungsform des erfindungsgemässen Befestigungselements ist dadurch gekennzeichnet, dass das Befestigungsmittel durch eine Schraube gebildet ist, welche in ihrer angezogenen Lage mit ihrem Kopf oder über eine Beilagscheibe die Leiterplatte und mit ihrem freien Ende den Träger kontaktiert.

Erfindungsgemäss weist die Schraube an ihrem freien Ende eine Spitze auf, welche beim Anziehen in den Träger oder in eine in diesem vorgesehene Bohrung hineingedreht wird.

Bei Verwendung der erfindungsgemässen Befestigungselemente werden die Träger mit Ausnehmungen zur Aufnahme der Befestigungsorgane und die Leiterplatten mit Löchern für die Schrauben versehen. Gegebenenfalls werden die Träger auch mit Bohrungen zur Aufnahme der Spitze der Schrauben versehen, was aber unterbleiben kann, wenn die Träger aus einem ausreichend weichen Material bestehen und beispielsweise durch Aluminiumschienen oder Aluminiumprofile gebildet sind. In diesem Fall ist es möglich, die Spitzen der Schrauben, deren Material selbstverständlich härter sein muss als Aluminium, in das volle Material der Träger hineinzudrehen.

Zur Befestigung einer Leiterplatte werden die Befestigungsorgane in die Ausnehmungen gesteckt, was auch bei extrem ungünstigen Einbauverhältnissen in einem grossen und unhandlichen Gehäuse kein Problem ist, weil die Ausnehmungen ertastet werden können.

Dann wird die Leiterplatte auf die in der Regel vier Distanzierungsmittel pro Leiterplatte aufgelegt und so positioniert, dass die Löcher in der Leiterplatte mit den Bohrungen der Distanzierungsmittel fluchten. Anschliessend werden die Schrauben durch die Löcher der Leiterplatte in die genannten Bohrungen gesteckt und angezogen, wodurch die Spitzen der Schrauben in den Träger oder in die in diesem vorgesehenen Bohrungen hineingedreht werden.

Im folgenden wird die Erfindung anhand eines Ausführungsbeispiels und der Zeichnungen näher erläutert; es zeigt:
- Fig. 1: eine Ansicht einer Verbindung zwischen einer Leiterplatte und einem Träger in vergrössertem Massstab,
- Fig. 2: eine Ansicht des Trägers in Richtung des Pfeiles II von Fig. 1,
- Fig. 3: eine Ansicht eines Details von Fig. 1 in nochmals vergrössertem Massstab; und

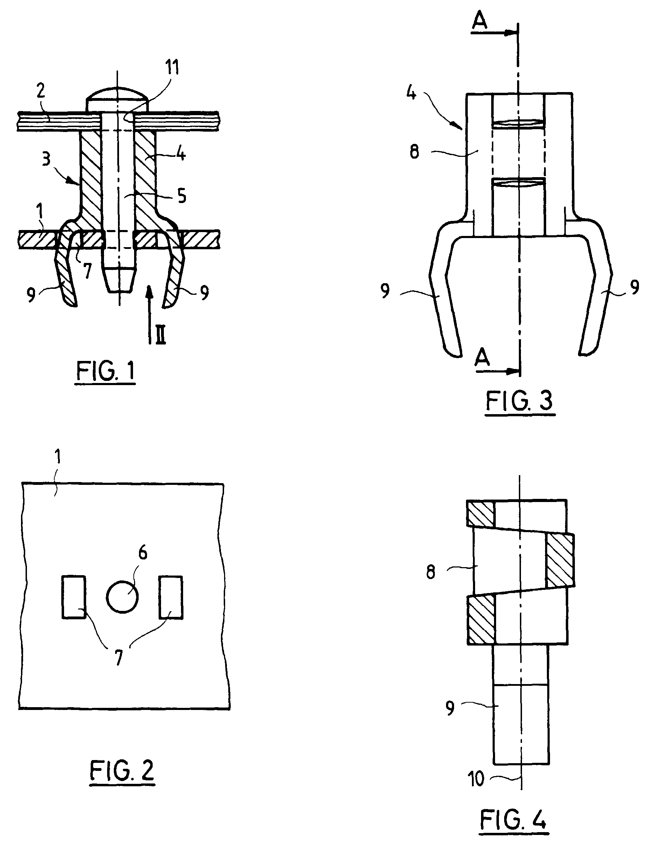

- Fig. 3: einen Schnitt nach der Linie A - A von Fig. 3.

Fig. 1 zeigt in einem schematischen Schnitt eine Verbindung zwischen einem Träger 1 und einer Leiterplatte 2 mit einem Befestigungselement 3, welches aus einem Distanzierungsmittel 4 und einer Befestigungsschraube 5 besteht. Wie Fig. 2 zu entnehmen ist, weist der beispielsweise durch eine Leichtmetallschiene gebildete Träger 1 an der für die Verbindung vorgesehenen Stelle eine Bohrung 6 und zu beiden Seiten von dieser zwei schlitzartige Ausnehmungen 7 auf. Der Durchmesser der Bohrung 6 ist etwas kleiner als der Durchmesser des Gewindeteils der Schraube 5, so dass die Bohrung 6 für die Schraube 5 wie eine Mutter wirkt und die Schraube 5 fixiert.

Wenn die Trägerschiene 1 aus einem ausreichend weichen Material besteht und ausreichend dünn ist, und wenn die Schraube 5 eine sogenannte Holz- oder Blechschraube mit einem entsprechenden Gewinde und einer relativ scharfen Spitze ist, dann kann die Bohrung 6 entfallen oder sehr viel kleiner sein als der Durchmesser der Schraube 5, weil die Schraube beim Anziehen die Trägerschiene 1 bzw. die Bohrung 6 entsprechend aufbohrt.

Das Distanzierungsmittel 4 besteht aus elastischem Kunststoff und weist gemäss den Figuren 1 und 3 einen hülsenförmigen Distanzierungsteil 8 und zwei an diesen angearbeitete finger- oder flügelartige Befestigungsorgane 9 auf, welche zum Eingriffin die schlitzartigen Ausnehmungen 7 der Trägerschiene 1 vorgesehen sind. Die Befestigungsorgane 9 sind gekrümmt oder abgeknickt ausgebildet und so dimensioniert, dass sie beim Einschieben in die Ausnehmungen 7 unter Spannung einrasten, wodurch das Befestigungselement 3 auf der Trägerschiene 1 fixiert ist.

Wie den Figuren 3 und 4 zu entnehmen ist, hat der Distanzierungsteil 8 die Form einer an ihrem Mantel teilweise durchbrochenen, zylindrischen Hülse, wobei der Mantel in der die Befestigungsorgane 9 enthaltenden Querebene aus vollem Material besteht (Fig. 1 und 3) und in der senkrecht dazu verlaufenden Querebene zu beiden Seiten der Längsachse 10 abwechselnd einen Bereich aus vollem Material oder eine Durchbrechung aufweist.

Die Befestigung einer Leiterplatte 2 aufden dafür vorgesehenen Trägerschienen 1 erfolgt derart, dass zuerst die Distanzierungsmittel 4 mit ihren Befestigungsorganen 9 in die Ausnehmungen 7 gedrückt und in diesen eingerastet werden. Anschliessend wird die Leiterplatte 2, die an den vorgesehenen Befestigungsstellen Bohrungen 11 zum Einschieben der Schrauben 5 aufweist, so auf die Distanzierungmittel 4 gelegt, dass die Bohrungen 11 der Leiterplatte 2 oberhalb der Distanzierungsmittel 4 zu liegen kommen, und dann wird an jeder Befestigungsstelle, gegebenenfalls unter Verwendung einer Beilagscheibe (nicht dargestellt), die Schraube 5 von der Leiterplatte 2 her in das Distanzierungsmittel 4 geschoben und schliesslich angezogen. Dabei wird die Schraube 5 in die Bohrung 6 der Trägerschiene 1 hineingedreht, wodurch eine mechanisch stabile und elektrisch leitende Verbindung zwischen der Trägerschiene 1 und der Leiterplatte 2 hergestellt wird.

## Patentansprüche

1. Befestigungselement zur beabstandeten Befestigung einer Leiterplatte (2) auf einem elektrisch leitenden Träger (1) unter Herstellung einer elektrisch leitenden Verbindung, dadurch gekennzeichnet, dass das Befestigungselement (3) aus einem auf dem Träger (1) fixierbaren Distanzierungsmittel (4) zur Auflage der Leiterplatte (2) und aus einem elektrisch leitenden Befestigungsmittel (5) zur Herstellung einer mechanischen, und elektrisch leitenden Verbindung zwischen der Leiterplatte (2) und dem Träger (1) besteht.

2. Befestigungselement nach Anspruch 1, dadurch gekennzeichnet, dass das Distanzierungsmittel (4) aus einem Kunststoffmaterial besteht und einen hülsenförmigen Distanzierungsteil (8) sowie einen an diesen angearbeiteten Befestigungsteil (9) aufweist.

3. Befestigungselement nach Anspruch 2, dadurch gekennzeichnet, dass der Befestigungsteil (9) durch zwei elastische, finger- oder flügelartige und zum Eingriff in entsprechende Ausnehmungen (7) des Trägers (1) vorgesehene Befestigungsorgane gebildet ist.

4. Befestigungselement nach Anspruch 3, dadurch gekennzeichnet, dass die Befestigungsorgane (9) so ausgebildet sind, dass sie beim Einschieben in die Ausnehmungen (7) des Trägers (1) unter Spannung in diese einrasten.

5. Befestigungselement nach einem der Ansprüche 1 bis 4, dadurch gekennzeichnet, dass das Befestigungsmittel (5) durch eine Schraube gebildet ist, welche in ihrer angezogenen Lage mit ihrem Kopf oder über eine Beilagscheibe die Leiterplatte (2) und mit ihrem freien Ende den Träger (1) kontaktiert.

6. Befestigungselement nach Anspruch 5, dadurch gekennzeichnet, dass die Schraube (5) an ihrem freien Ende eine Spitze aufweist, welche in den Träger (1) oder in eine in diesem vorgesehene Bohrung (6) hineingedreht wird.

7. Befestigungselement nach Anspruch 6, dadurch gekennzeichnet, dass die Schraube (5) eine Holz- oder Blechschraube ist.
